Europäisches Patentamt

European Patent Office

Office européen des brevets

(11) Veröffentlichungsnummer : **0 134 433**
**B1**

(12) **EUROPÄISCHE PATENTSCHRIFT**

(45) Veröffentlichungstag der Patentschrift :
25.05.88

(21) Anmeldenummer : 84106912.3

(22) Anmeldetag : 16.06.84

(51) Int. Cl.⁴ : **H 03 K  3/55, H 03 K  3/57,
H 01 F  7/18, H 05 H  7/04**

(54) Ansteuerungsschaltung für Pulsstromgeräte.

(30) Priorität : 15.07.83 DE 3325502

(43) Veröffentlichungstag der Anmeldung :
20.03.85 Patentblatt 85/12

(45) Bekanntmachung des Hinweises auf die Patenterteilung : 25.05.88 Patentblatt 88/21

(84) Benannte Vertragsstaaten :
AT BE CH DE FR GB IT LI LU NL SE

(56) Entgegenhaltungen :
DE-A- 3 010 674
DE-B- 2 758 227
PATENT ABSTRACTS OF JAPAN, Band 1, Nummer
146, 26 November 1977, Seite 7411 E 77; & JP-A-52-
84958 (HITACHI SEISAKUSHO) 14-07-1977
PATENT ABSTRACTS OF JAPAN, Band 7, Nummer
267, 29 November 1983; & JP-A-58-148666 (KOUS-
HIYUUHA NETSUREN K.K.) 03-09-1983
GEC JOURNAL OF SCIENCE & TECHNOLOGY, Band
48, Nummer 3, 1982, Rugby, GB; M.L. WOODHOUSE
et al. "Control and protection of thyristors in the
English terminal valves", Seiten 135-140

(73) Patentinhaber : Deutsches Elektronen-Synchrotron
DESY
Notkestrasse 85
D-2000 Hamburg 52 (DE)

(72) Erfinder : Rümmler, Jürgen
Vosskoppel 4
D-2000 Hamburg 53 (DE)

(74) Vertreter : UEXKÜLL & STOLBERG Patentanwälte
Beselerstrasse 4
D-2000 Hamburg 52 (DE)

**Beschreibung**

Die Erfindung betrifft eine Ansteuerungsschaltung für Pulsstromgeräte.

Aus der DE-A-30 10 674 ist eine Ansteuerungsschaltung für Stromventile (Thyratrons, Thyristoren) bekannt, welche dazu dient, das Stromventil vor Einschaltstromspitzen zu schützen. Sie weist eine Induktivität auf, zu der ein Umladekondensator parallel geschaltet ist. Eine Umladung des Kondensators erfolgt über eine parallel zum Kondensator geschaltete Rückladedrossel und eine mit dieser in Reihe angeordnete Rückladediode.

Aus der DE-B-27 58 227 ist eine dv/dt-Schutzschaltungsanordnung für einen GTO-Thyristor bekannt, die einen Ringbandkern aufweist, um den Strom beim Abschalten des GTO-Thyristors zu begrenzen.

Derartige Schaltungen dienen beispielsweise zum Betreiben von Kickermagneten, welche in Elektronen- oder Protonen-Beschleunigeranlagen dazu dienen, den umlaufenden Elektronen- oder Protonenpaketen die gewünschte Richtung beim Ein- oder Ausschuß in den Beschleunigerring zu geben. Dies ist insbesondere an Injektions- und Ejektionsstellen einer Hauptumlaufbahn erforderlich, da die Einlenkung oder Auslenkung eines Elektronen- oder Protonenstrahls aufgrund der Anordnung der Strahlführungsmagnete nicht exakt tangential erfolgen kann, sondern nur einem kleinen Restwinkel von 2 bis 4° gegen die Bahntangente durchführbar ist. Dieser kleine Restwinkel kann durch das Einschalten von Kickermagneten beseitigt werden, die aber immer nur dann aktiv sein dürfen, wenn ein Elektronen- oder Protonenpaket gerade durch die Einschußstelle und damit durch den Kickermagneten läuft. Da Elektronen in Beschleunigeranlagen praktisch mit Lichtgeschwindigkeit und in Form von einzelnen, diskreten Paketen kreisen, ist es absolut notwendig, daß der Kickermagnet genau zum richtigen Zeitpunkt erregt wird, um dem durchlaufenden Elektronenpaket die gewünschte Richtung zu geben. Dies hat man bislang dadurch erreicht, daß ein Thyratron verwendet wurde, beispielsweise des Typs CX1154 oder CX1174 der Firma English Elektric Valve Company Ltd. Ein Nachteil besteht darin, daß hohe Abrißspannungen zur Löschzeit des Thyratrons, die der Hersteller nur begrenzt zuläßt, am Ende des Stromimpulses den Einsatz und die Lebensdauer der Röhre stark einschränken. Ein weiterer Nachteil ist darin zu sehen, daß nach dem erwünschten Pulsstromende noch freie Ladungsträger im Thyratron enthalten sind, welche den Löschstrom zunächst negativ und dann steil gegen Null abfallen lassen. Diese Ladungsausräumung führt zu einem schnellen Stromabriß di/dt von etwa 2 000 A/μs und wirkt daher wie eine schnelle Induktivitätsabschaltung, bei der hohe, rückwärts gerichtete Schaltspannungen in dem Pulsstromgerät induziert werden. Die Abschaltspannungen dürfen aber einen bestimmten Höchstwert nicht überschreiten, beispielsweise 10 kV für die ersten 25 μs nach dem Anodenimpuls für die erwähnten Thyratrons des Typs CX1154 oder CX1174, da es sonst zu Zerstörungen des elektrischen Stromventils durch Überschläge und Rückzündungen kommt. Das gleiche gilt für den Einsatz von Thyristoren, wobei allerdings die Grenzwerte anders liegen.

Da die bekannten Thyratrons somit in Rückwärtsrichtung keiner höheren Abrißspannung als 10 kV ausgesetzt werden können, darf auch ihre Anodenspannung diesen Wert nicht überschreiten, so daß die erwähnten Thyratrons lediglich mit Vorwärtsspannungen an der Anode von 9 kV betrieben wurden, obgleich als Vorwärtsspannung 40 kV maximal zulässig wären.

Es ist daher Aufgabe der Erfindung, eine Ansteuerungsschaltung für Pulsstromgeräte dahingehend zu verbessern, daß das elektrische Stromventil mit höherer Vorwärtsspannung als bislang betrieben werden kann.

Zur Lösung dieser Aufgabe dient eine Ansteuerungsschaltung gemäß Anspruch 1.

Durch die Verwendung eines oder mehrerer Ringbandkerne, die eine rechteckförmige Hysteresis-Kurve haben, wird bis zum Erreichen der magnetischen Sättigung des Ringbandkerns ein großer Spannungsabfall in dem im Bereich des Ringbandkerns liegenden Leitungsabschnitt erreicht, der zusammen mit dem parallel zum Stromventil liegenden Widerstand einen Spannungsteiler bildet. In Verbindung mit dem in Reihe geschalteten zweiten Kondensator verlangsamt dieser den Stromanstieg des Löschstroms und dämpft damit die Löschkennlinie im negativen Teil. Dies hat wiederum zur Folge, daß unter Beachtung des Grenzwerts für die Rückwärtsspannung eine höhere Vorwärtsspannung an die Anode des Stromventils gelegt werden kann. Eine höhere Vorwärtsspannung hat aber auch eine größere Ladung auf dem ersten Kondensator und damit auch einen höheren Stromimpuls zur Folge, so daß die erfindungsgemäße Schaltung bei gleicher Impulshöhe in der Lastinduktivität, beispielsweise im Kicker- oder Septummagneten, mit einem kleineren Stromventil, insbesondere Thyratron, betrieben werden kann.

Die gleichen Vorteile ergeben sich beim Einsatz eines Thyristors als Stromventil, wobei sich lediglich die Grenzwerte ändern.

Die Erfindung wird im folgenden anhand von Figuren näher erläutert ; es zeigen :

Figur 1 ein Schemaschaltbild eines Ausführungsbeispiels der Schaltung ;

Figur 2 einen Hysteresis-Kurve eines in der Schaltung gemäß Figur 1 eingesetzten Ringbandkerns ; und

Figur 3 ein Strom- und Spannungsdiagramm, das mit der Schaltung gemäß Figur 1 erzielbar ist.

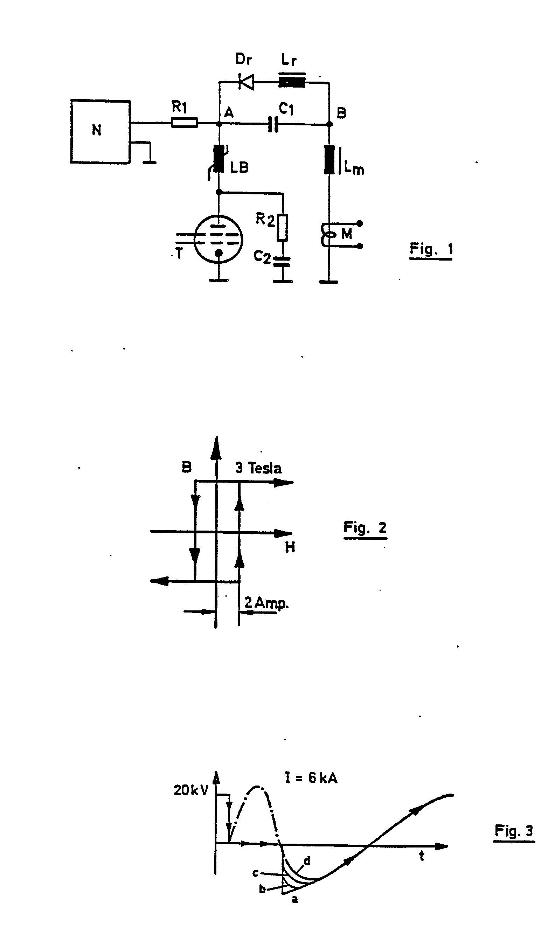

Figur 1 zeigt ein Netzgerät N, das über einen Nachladewiderstand R1 und einen ersten kondensator C1 an eine Lastinduktivität Lm angeschlossen ist. Die Lastinduktivität Lm ist beispielsweise ein Magnet, der in Beschleunigeranlagen zur schnellen Bahnkorrektur von Beschleunigerteilchenpaketen eingesetzt wird. Das nicht mit dem ersten Kondensator C1 verbundene Ende der Lastinduktivität Lm ist ebenso wie der andere Pol des Netzteils N an Masse gelegt. Ein Meßwandler M umgibt das Leitungsstück zwischen Lastinduktivität Lm und Masse. Für die Erfindung ist dieser Meßwandler M jedoch nicht von Bedeutung.

Parallel zu dem ersten Kondensator C1 sind eine Rückladedrossel Lr und eine Rückladediode Dr geschaltet, wobei die Rückladediode Dr mit ihrer Kathode zwischen dem Nachladewiderstand R1 und dem ersten Kondensator C1 an einem Punkt A angeschlossen ist. Die Anode der Rückladediode Dr liegt an einem Ende der Rückladedrossel Lr, deren anderes Ende zwischen dem ersten Kondensator C1 und der Lastinduktivität Lm in einem Punkt B angeschlossen ist. Der erste Kondensator C1 und die Rückladedrossel Lr bilden einen langsamen Schwingkreis zur Rückladung des ersten Kondensators C1 nach einer Entladung des ersten Kondensators C1 über ein gegen Masse geschaltetes Thyratron T.

Das Thyratron T liegt mit seiner Anode am Punkt A, wobei der Leitungsabschnitt zwischen der Thyraton-Anode und dem Punkt A der Schaltung von einem Ringbandkern LB umgeben ist. Die Form und Wirkungsweise des Ringbandkerns LB wird anhand von Figur 2 näher erläutert. Parallel zum Thyratron T sind ein zweiter Widerstand R2 und zweiter Kondensator C2 gegen Masse geschaltet, wobei ein Ende des Widerstands R2 an der Anode und das andere Ende an dem zweiten Kondensator C2 liegt.

Figur 2 zeigt die Hysteresis-Kurve für einen erfindungsgemäß verwendbaren Ringbandkern, der beispielsweise aus hochwertigem Z-Eisen gefertigt ist. Ein Ringbandkern ist ein spiralförmig gewickelter Weicheisenstreifen, dessen einzelne Lagen gegeneinander isoliert sind. Seine Hysteresis-Kurve ist rechteckförmig und man erkennt, daß er nach Überschreiten eines bestimmten kleinen Sättigungsstroms von beispielsweise 2 Ampere schlagartig in die Sättigung gelangt. Bis zum Erreichen der Sättigung wird der Ringbandkern von dem Magnetfeld des zur Anode des Thyratrons fließenden Stroms ummagnetisiert und wirkt damit als induktiver Widerstand, der zusammen mit dem Widerstand R2 einen Spannungsteiler bildet. Dieser Spannungsteiler stellt in Verbindung mit dem zweiten Kondensator C2 ein RC-Glied dar, welches hochfrequente Schwingungen beim Abschaltvorgang dämpft. Ein Ringbandkern wirkt bis zur Sättigung wie eine hohe Induktivität, während er nach der Sättigung magnetisch und damit auch elektrisch wirkungslos ist. Der Aufladestrom für den zweiten Kondensator C2 treibt den oder gegebenenfalls die Ringbandkerne LB in die Sättigung ; der Nutzpuls bzw. Pulstrom hat die gleiche Stromrichtung wie der Aufladestrom. Durch den Nutzpuls wird der Sättigungszustand des oder der Ringbandkerne LB nicht geändert und der Pulsstrom wird nicht beeinträchtigt. Da während der Durchsteuerung des Thyratrons T innerhalb weniger Nanosekunden ein hoher Strom fließt, wird der Ringbandkern LB schnell in die Sättigung gebracht und hat daher keinen Einfluß auf den Pulsverlauf. Nach dem Sperren des Thyratrons T fließt jedoch nur ein kleiner Rückladungsstrom, welcher den Ringbandkern LB umpolt, aus der Sättigung bringt und ihn wieder zu einer hohen Induktivität werden läßt.

Figur 3 zeigt diese Verhältnisse anhand eines Strom- und Spannungsdiagramms, wobei die Abschaltspannung als voll ausgezogene Kurve dargestellt ist. Hingegen ist der Stromimpuls für den Magneten Lm strichpunktiert angedeutet.

Die Kurve a zeigt eine hohe Abschaltspannung bei lediglich RC-Beschaltung des Thyratrons T, jedoch ohne Ringbandkern LB. Die Kurve b zeigt den Einfluß eines Ringbandkerns LB, welcher die Löschkennlinie am Thyratron T dämpft.

Die Kurven c und d zeigen günstigere Kennlinien, welche sich durch höhere R2, C2 und LB-Werte ergeben.

## Patentansprüche

1. Ansteuerungsschaltung für Pulsstromgeräte mit einer ersten Induktivität (Lm) als Verbraucher, die über einen ersten Kondensator (C1) an ein Netzteil (N) angeschlossen ist, mit einem zwischen dem ersten Kondensator (C1) und dem Netzteil (N) mit seiner Anode angeschlossenen steuerbaren elektrischen Ventil (T), und mit parallel zum ersten Kondensator (C1) geschalteter Rückladedrossel (Lr) und Rückladediode (Dr), bei der vor die Anode des elektrischen Ventils (T) ein Ringbandkern (LB) geschaltet ist und parallel zu dem elektrischen Ventil (T) ein Widerstand (R2) und ein mit diesem in Reihe angeordneter zweiter Kondensator (C2) derart liegen, daß der Widerstand (R2) mit einem Ende an der Anode des elektrischen Ventils (T) und mit dem anderen Ende an dem zweiten Kondensator (C2) angeschlossen ist.

2. Ansteuerungsschaltung nach Anspruch 1, dadurch gekennzeichnet, daß das elektrische Ventil (T) ein Thyratron ist.

3. Ansteuerungsschaltung nach Anspruch 1, dadurch gekennzeichnet, daß das elektrische Ventil (T) ein Thyristor ist.

## Claims

1. A triggering circuit for pulse current apparatus, having a first inductance (Lm) as the load which is connected via a first capacitor (C1) to part (N) of a network, having a controllable electric valve (T) connected by its anode between the first capacitor (C1) and the part (N) of the network, and having a reverse-charging choke (Lr) and a reverse-charging diode (Dr) connected in parallel with the first capacitor (C1), in which before the anode of the electric valve (T) a toroidal tape core (LB) is connected and in parallel with the electric valve (T) a resistor (R2) and a second capacitor (C2) arranged in series with the latter are connected in such a way that the resistor (R2) is connected by one end to the anode ot the electric valve (T) and by the other end to the second capacitor (C2).

2. A triggering circuit as in Claim 1, characterized in that the electric valve (T) is a thyratron.

3. A triggering circuit as in Claim 1, characterized in that the electric valve (T) is a thyristor.

**Revendications**

1. Circuit de commande pour appareils à courant impulsionnel, avec une première inductance (Lm) comme dispositif d'utilisation, qui est connectée, par l'intermédiaire d'un premier condensateur (C1), à une partie de réseau (N), avec une valve électrique (T) susceptible d'être commandée, connectée, par son anode, entre le premier condensateur (C1) et la partie de réseau (N), et avec, en parallèle au premier condensateur (C1), une bobine de régénération (Lr) et une diode de régénération (Dr), où, avant l'anode de la valve électrique (T), est branché un noyau à bandes toroïdales (LB) et où, parallèlement à la valve électrique (T), sont montés une résistance (R2) et un deuxième condensateur (C2) en série avec elle, de façon que la résistance (R2) soit connectée, par une extrémité, à l'anode de la valve électrique (T) et, par l'autre extrémité, au deuxième condensateur (C2).

2. Circuit de commande suivant la revendication 1, caractérisé en ce que la valve électrique (T) est un thyratron.

3. Circuit de commande suivant la revendication 1, caractérisé en ce que la valve électrique (T) est un thyristor.

Fig. 1

Fig. 2

Fig. 3